# EUROPÄISCHE PATENTANMELDUNG

(11) **EP 1 529 922 A2**
(43) Veröffentlichungstag der Anmeldung: **11.05.2005**
(21) Anmeldenummer: 04025367.6
(22) Anmeldetag: 26.10.2004
(51) Int. Cl.: E06B 3/667, H01B 17/26

(54) **Mehrfachscheibe mit einer Leitungsdurchführung**

(30) Priorität: 05.11.2003 DE 10351677
(71) Anmelder: Saint-Gobain Glass France, 92400 Courbevoie (FR)
(72) Erfinder: Schaumberger, Franz, 4421 Aschach (AT)
(74) Vertreter: Dederichs, August

(57) **Zusammenfassung**

Eine Mehrfachscheibe (1), insbesondere eine lsolierglasscheibe, aus mindestens zwei flächigen Scheiben (2, 4) und einem diese miteinander verbindenden umlaufenden Abstandhalterahmen (3), welcher einen Scheibenzwischenraum (5) umschreibt, umfasst eine in den Abstandhalterahmen eingesetzte Leitungsdurchführung. Diese besteht aus einem mit dem Abstandhalterahmen auf zwei Seiten gasdicht verbundenen Körper (7) und mindestens einem fest, gasdicht und gegenüber dem Abstandhalter isoliert in den Körper eingesetzten Leiterabschnitt (8). Erfindungsgemäß ersetzt der Körper (7) einen Eckbereich des Abstandhalterahmens (3) derart, dass er zwei winklig zueinander verlaufende Schenkel des Abstandhalterahmens (3) miteinander verbindet. Vorzugsweise bildet die Leitungsdurchführung den oder die Anschlüsse für im Scheibenzwischenraum befindliche elektrische Funktionselemente.

## Beschreibung

Die Erfindung bezieht sich auf eine Mehrfachscheibe, insbesondere auf eine Isolierglasscheibe, mit einer Leitungsdurchführung mit den Merkmalen des Oberbegriffs des Patentanspruchs 1.

Diese Merkmale ergeben sich aus DE 44 02 449 A1, wo eine Anordnung zum elektrisch leitenden Verbinden von wenigstens einem im Innenraum einer Isolierglasscheibe angeordneten Bauteil (z. B. Fotozellen, elektrische Heizung und dgl.) mit wenigstens einem Bauteil beschrieben wird, das sich außerhalb der Isolierglasscheibe befindet. Nach dieser Beschreibung wird in den Abstandhalterahmen der Isolierglasscheibe ein metallischer Stift mithilfe eines Kunststoffklotzes eingesetzt, der seinerseits in eine Lücke eines der Schenkel des Abstandhalters eingesetzt ist. Mit dieser Lösung soll die gewünschte Dichtheit des Abstandhalters und des Scheibenzwischenraums gewährleistet bleiben. Die Enden des metallischen Stiftes stehen zu beiden Seiten über den Abstandhalter vor und können dort als Steck- oder Schraubanschlüsse genutzt werden.

Aufgrund der Verwendung eines im Wesentlichen gasdicht an den Abstandhalterahmen angeschlossenen Körpers mit integriertem Leiterabschnitt anstelle einer nicht-gasdichten Kabeldurchführung beobachtet man eine erhebliche Verlängerung der Nutzungsdauer als effektive Isolierglasscheibe mit signifikant verringertem Energiedurchgang.

Weiters treten in der Transport, Verglasungs- und Einbauphase der bekannten Scheibe keine Probleme mit abgerissenen Kabeln auf da auch nach der Montage ein Anstecken oder Anlöten der Verbindung ermöglicht ist.

Das Patent DE 1 278 292 beschrieb eine Alarmglasscheibe, die ebenfalls als Mehrfachscheibe ausgeführt sein kann, deren eine Scheibe mit einer anhaftenden, beim Bruch der Scheibe zerstörbaren elektrischen Leiterbahn versehen ist. Die elektrische Verbindung zu dieser Leiterbahn kann auch dort durch Einsetzen einer Kabeldurchführung in den Abstandhalterahmen einer Isolierglasscheibe hergestellt werden. Auf das Problem der Abdichtung geht diese Druckschrift nicht näher ein.

EP 345 007 B1 beschreibt eine Isolierverglasung mit einer elektromotorisch beweglichen, innen liegenden Jalousie. Der Elektromotor ist bei dieser bekannten Lösung in ein Gehäuse eingesetzt, das in einen Eckbereich des Abstandhalterahmens eingesetzt ist. Das Gehäuse ist insgesamt L-förmig ausgebildet und hat an seinen beiden Enden jeweils Zapfen, die in die anstoßenden Hohlräume der Abstandhalter-Profile dicht einsetzbar sind. Auf der Außenseite werden elektrische Anschlüsse für den Motor eingeführt, auf der Innenseite (zum Scheibenzwischenraum hin) ist die Antriebswelle des Motors durchgeführt.

Der Erfindung liegt die Aufgabe zu Grunde, eine weitere Lösung für eine Leitungsdurchführung in einer Mehrfachscheibe des gattungsgemäßen Typs anzugeben.

Diese Aufgabe wird erfindungsgemäß mit den Merkmalen des Patentanspruchs 1 gelöst. Die Merkmale der Unteransprüche geben vorteilhafte Weiterbildungen dieser Erfindung an.

Wird der Körper der Leitungsdurchführung in einen Eckbereich des Abstandhalterahmens eingesetzt, so kann die elektrische Kontaktierung besonders unauffällig in die Mehrfachscheibe integriert werden. Zugleich kann der Körper die Funktion eines Eckverbinders übernehmen und damit einen Abschnitt des Abstandhalterahmens ersetzen. Es versteht sich, dass er nicht nur als 90°-Verbinder, sondern für andere mehreckige Umrisse der Isolierglasscheiben auch mit von 90° abweichenden Winkeln ausgeführt werden kann.

Es ist auch nicht unbedingt erforderlich, diesen Körper direkt als den Träger der Leiterabschnitte auszubilden. Er kann vielmehr auch als Träger eines Zwischenstücks ausgeführt werden, das seinerseits die elektrischen Leiterabschnitte trägt. Selbstverständlich müssen die Fügeverbindungen zwischen dem Körper und dem Abstandhalterahmen sowie den starren Scheiben einerseits und ggf. zwischen dem Körper und dem besagten Zwischenstück andererseits so gut abgedichtet werden, dass die Funktion des Isolierglases langfristig unbeeinträchtigt bleibt.

Die Außenanschlüsse können damit auch nach der Fertigstellung der Mehrfachscheibe hergestellt (durch Löten, Anschrauben, Stecken) und bei Bedarf jederzeit repariert werden. Von Vorteil ist es, wenn die Außenanschlüsse so in den Körper der Leitungsdurchführung eingesetzt werden, dass sie nicht oder nur wenig über dessen Außenumriss (und auch nicht über den Rand der Mehrfachscheibe) vorstehen. Damit sind sie bestmöglich vor Beschädigungen geschützt.

Eine solche Leitungsdurchführung ist für vielfältige Verwendungszwecke nutzbar; neben Solarzellen, Alarmschleifen und/oder Heizungselementen können auch Leuchtelemente (z. B. auf Elektrolumineszenz-Basis) oder Elemente mit veränderlicher Lichttransmission (elektrochrom, Flüssigkristall) mit Vorteil in eine solche Mehrfachscheibe eingebaut und elektrisch angeschlossen werden.

Weitere Einzelheiten und Vorteile des Gegenstands der Erfindung gehen aus der Zeichnung eines Ausführungsbeispiels und deren sich im folgenden anschließender eingehender Beschreibung hervor.

Es zeigen in vereinfachter, nicht maßstäblicher Darstellung
- Fig. 1: eine Gesamtansicht einer erfindungsgemäßen Mehrfachscheibe,
- Fig. 2: eine gegenüber Fig. 1 vergrößerte Seitenansicht eines Details des Eckbereichs mit der Leitungsdurchführung,
- Fig. 3: eine Schnittansicht des Eckbereichs entlang Linie III-III in Fig. 2.

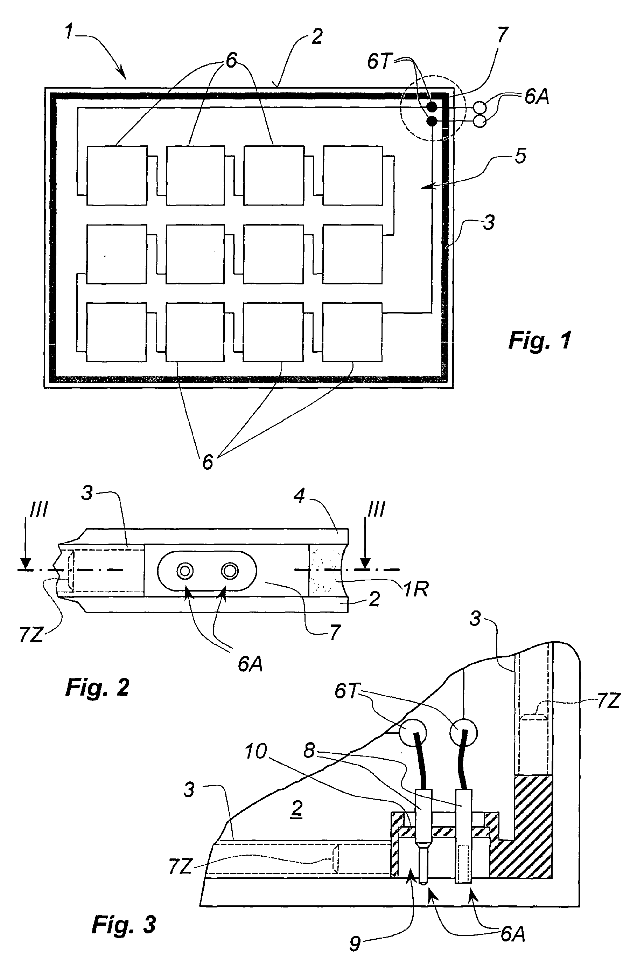

Gemäß **Fig. 1** umfasst eine Mehrfachscheibe 1 eine erste starre Scheibe 2 und eine mit dieser deckungsgleich über einen Abstandhalterahmen 3 verbundene weitere starre Scheibe 4 (s. Fig. 2). Die Mehrfachscheibe 1 bildet also eine Isolier(glas)scheibe mit einem durch den Abstandhalterahmen 3 definierten und umschriebenen Scheibenzwischenraum 5. Innerhalb des letztern sind elektrische Funktionselemente, hier in Gestalt von Solarzellen 6, angeordnet. Diese können in an sich bekannter Weise auf einer der innen liegenden Oberflächen einer der Scheiben 2 oder 4 befestigt sein. Sollte eine der Scheiben 2 oder 4 ihrerseits als Verbundscheibe aus mindestens zwei starren Scheiben und einer diese verbindenden Klebeschicht ausgeführt sein, so können die Solarzellen (oder anderweitige Funktionselemente, wie bereits weiter oben erwähnt) auch innerhalb dieses Scheibenverbundes angeordnet sein. Die hier gezeigte Mehrfachscheibe bildet einen Solarmodul mit einer durch die Anzahl der Solarzellen definierten elektrischen Leistung.

Es versteht sich, dass die Mehrfachscheibe grundsätzlich jede beliebige Form und Größe haben kann, und dass auch innerhalb ein und derselben Mehrfachscheibe mehrere Arten elektrischer Funktionselemente vorgesehen werden können.

Die erfindungsgemäße Lösung befasst sich mit dem Problem des Herausführens von elektrischen Anschlüssen (in der Regel mindestens zwei Leitungen, bei einer im Scheibenzwischenraum angeordneten Antenne kann es auch nur eine einzelne Leitung sein) aus dem Scheibenzwischenraum 5 nach außen.

Im vorliegenden konkreten Ausführungsfall muss die elektrische Leistung der miteinander in Reihe geschalteten Solarzellen 6 (des Solarmoduls) außerhalb der Mehrfachscheibe 1 verfügbar gemacht werden. In einem Eckbereich der Mehrfachscheibe 1 bzw. des Abstandhalterahmens 3 sind innerhalb des Scheibenzwischenraums 5 zwei Anschlusspunkte 6T der Solarzellen-Reihenschaltung dargestellt, die als Lötflächen (z. B. durch Siebdrucken direkt auf die Scheibenoberfläche oder auch auf einer aufzuklebenden Leiterplatine hergestellt) ausgeführt sein können. Ihnen liegen außerhalb des Scheibenzwischenraums zwei Außenanschlüsse 6A gegenüber.

In einer möglichen Ausführung der Mehrfachscheibe können die Solarzellen ihrerseits in eine Verbundscheibe eingebettet sein, die dann die starre Scheibe 2 bildet. Dann wären die Anschlüsse für die Solarzellen durch eine Ausnehmung in der Scheibe zu führen, die dem Scheibenzwischenraum 5 zugewandt ist, und mit den Anschlüssen 6T zu verbinden, z. B. durch aufgedruckte Leiterbahnen.

In Fig. 1 ist der vorerwähnte Durchführungs- und Anschlussbereich, auf den im Folgenden detaillierter einzugehen sein wird, durch einen gestrichelten Kreis bezeichnet. Ein (in Fig. 1 nur vereinfacht dargestellter) Körper 7 einer Leitungsdurchführung ist als Teilabschnitt und zugleich als Eckverbinder des (hohlen) Abstandhalterahmens 3 in diesen eingesetzt. Dieser Körper 7 verbindet also die beiden im Eckbereich aufeinander zu laufenden Schenkel des Abstandhalterahmens 3. Er wird mit den beiden zueinander weisenden Oberflächen der starren Scheiben unmittelbar verklebt. Das bedeutet, dass er, senkrecht zu den Scheibenflächen gesehen, höchstens gleich hoch wie der Abstandhalter selbst sein darf. In einer bevorzugten Ausführung besteht dieser Körper aus Kunststoff (Polybutylen- oder Polyethylen-Terephthalat) mit 60 % Glaskugel-Anteil.

In der Seitenansicht der **Fig. 2** (Blickrichtung von rechts auf den Durchführungs- und Anschlussbereich in Fig. 1) erkennt man die Anordnung sowohl des Abstandhalterahmens 3 (von dem hier nur ein kurzer Abschnitt des in Fig. 1 vertikal verlaufenden Schenkels sichtbar ist) als auch des Körpers 7 der Leitungsdurchführung zwischen den beiden starren Scheiben 2 und 4. Die Verklebungen zwischen den Scheiben und dem Abstandhalterahmen bzw. dem Körper 7 sind hier nicht weiter dargestellt. Mit 1R ist jedoch eine umlaufende Randabdichtung (z. B. aus Polysulfid) der Mehrfachscheibe 1 angedeutet, welche in an sich bekannter Weise eine Randnut ausfüllen wird, die durch einen geringen Einzug der Außenfläche des Abstandhalterahmens 3 gegenüber den Außenkanten der starren Scheiben 2 und 4 gebildet wird. Die Randabdichtung wird im Bereich der Außenanschlüsse 6A natürlich unterbrochen werden. Nach dem Herstellen der elektrischen Verbindungen kann dort eine Füll- oder Vergussmasse zur hermetischen Versiegelung des Anschlussbereiches vorgesehen werden.

Grundsätzlich kann auch die Randabdichtung erst nach dem Herstellen der elektrischen Außenanschlüsse, und dann in einem Arbeitsgang umlaufend angebracht werden. Wenn auch hier die beiden Scheiben 2 und 4 als gleich groß angenommen werden, so lässt sich die Erfindung ohne weiteres auch bei sogenannten Stufen-Isolierscheiben anwenden, bei denen eine Scheibe größerflächig als die andere ist.

Im Hinblick auf die Funktion einer Isolierglasscheibe, deren Scheibenzwischenraum möglichst gasdicht gegen die Umgebung abgeschlossen sein sollte, sind an die Übergänge zwischen den besagten Schenkeln und dem Körper sowie an die flächigen Klebestellen zwischen dem Körper und den innen liegenden Oberflächen der starren Scheiben mindestens dieselben Anforderungen zu stellen, die auch an die Verklebung des "normalen" Abstandhalterahmens gestellt werden. Man erkennt in Fig. 2 ferner einen Zapfen 7Z (gestrichelt), der mit dem Körper 7 fest (z. B. einstückig) verbunden und in das Hohlprofil des Schenkels des Abstandhalterahmens eingesteckt ist.

Von dem Körper 7 umfasst sind zwei Außenanschlüsse 6A, deren nähere Einzelheiten anhand von **Fig. 3** besser erkennbar sind. Die Schnittdarstellung der Fig. 3 zeigt im Aufriss wieder den Körper 7, der mithilfe zweier Zapfen 7Z über Eck mit zwei Schenkeln des Abstandhalterahmens mechanisch verbunden ist. Diese Zapfen unterstützen die Dichtheit der Füge- oder Verbindungsstellen. Ersichtlich kann der Körper 7 parallel zu den Oberflächen der Scheiben 2 und 4 gesehen größere Abmessungen als der Abstandhalterahmen haben.

Die Außenanschlüsse 6A werden hier durch die Enden zweier Stifte 8 verkörpert, die möglichst dicht in den Körper 7 eingesetzt sind. Die Stifte 8 (oder ähnliche gasdicht durch den Körper führbare Mittel) bilden Leiterabschnitte zum Durchführen von Strom oder Spannung durch den Abstandhalterahmen 3. Sie sind bevorzugt geometrisch unterschiedlich ausgebildet (Formcodierung), um Verwechslungen der elektrischen Pole möglichst vorzubeugen. Im vorliegenden Fall ist auf der Außenseite der Mehrfachscheibe 1 der eine Stift als Steckerstift und der andere als Steckhülse ausgeführt. Mithilfe eines passenden (hier nicht dargestellten) Steckers ist hier eine schnelle und einfache elektrische Kontaktierung der Solarzellen 6 mit weiteren Solarmodulen oder mit Abnehmern des erzeugten Stroms möglich.

Im Scheibenzwischenraum sind die Stifte 8 mithilfe kurzer Kabelabschnitte mit den Terminal-Anschlüssen 6T der Solarzellen elektrisch über Lötstellen verbunden. In einer anderen Ausführung können die Kabelabschnitte durch (gedruckte) Leiterbahnabschnitte ersetzt werden, die sich auf der Fläche der Glasscheibe 2 über die Anschlüsse 6T hinaus und anschließend zur Überbrückung des Höhenunterschieds über den Körper 7 bis zu den Stiften 8 erstrecken.

An die Stelle der gelöteten Kabel- oder Leiterbahnverbindungen zu den Solarzellen oder sonstigen elektrischen Funktionselementen könnten allerdings auch andere Kontaktmittel treten, z. B. Rast-, Steck- oder Federkontakte an den innen liegenden Enden der Stifte 8, die beim positionsrichtigen Auflegen des mit dem Körper 7 bestückten Abstandhalterahmens 3 schon gleich mit den zugehörigen Kontaktflächen 6T oder mit entsprechenden Gegenelementen an diesen Kontaktflächen in Berührung kommen. Es liegt auch im Rahmen der vorliegenden Erfindung, die Kontaktflächen 6T nicht auf einer Oberfläche einer starren Scheibe 2 oder 4 auszubilden, sondern an einem weiteren im Scheibenzwischenraum befindlichen Körper, der seinerseits z. B. auf einer dem Körper 7 zugewandten Stirnfläche diese Gegenkontaktflächen oder andere geeignete Kontaktelemente der vorstehend erwähnten Art trägt.

Gegen die Verwendung von Federkontakten oder ähnlichen lötfreien Lösungen bestehen in diesem konkreten Anwendungsfall keine Bedenken, da sie sich in dem gegen Umgebungseinflüsse (Verschmutzung, korrosive Angriffe, Luftfeuchtigkeit) praktisch hermetisch abgeschlossenen Scheibenzwischenraum befinden. Natürlich lassen sich dessen ungeachtet bei Bedarf auch diese Verbindungen durch Löten stabilisieren.

Zumindest an der Außenseite des Körpers 7 stehen die Steckerstifte 8 mit Vorzug nicht oder nur wenig über den Körper 7 vor. Sie befinden sich im hier gezeigten Ausführungsbeispiel innerhalb einer nach außen hin offenen Ausnehmung 9 des Körpers 7, die das Einstecken eines zweipoligen Steckers ermöglicht. Die schon erwähnte Formcodierung dieser elektrischen Anschlüsse kann natürlich auch durch elektrisch passive Formelemente innerhalb der Ausnehmung erreicht werden, in die der passende Stecker nur in der vorgeschriebenen Stellung einschiebbar ist.

Es ist auch denkbar, in der Ausnehmung 9 statt der auskragenden Steckerstifte 8 Leiterbahnen bzw. Gleitkontakte (aus Metallblech oder -folie) vorzusehen, die sich entlang der Seitenwand der Ausnehmung erstrecken und durch Einschieben eines entsprechend ausgestatteten Steckers kontaktiert werden.

Der relativ dünne Boden 10 der Ausnehmung 9 kann einstückig mit dem Körper 7 ausgebildet sein, wie hier (vereinfacht) dargestellt. In diesem Fall ist der ganze Körper 7 aus elektrisch isolierendem Material herzustellen.

Der Boden 10 kann aber auch durch eine Platine aus nicht leitfähigem Material gebildet sein (nur durch gestrichelte Linien angedeutet), die getrennt vom Körper 7 gefertigt und später möglichst gasdicht mit ihm verbunden wird, z. B. durch Kleben entlang einer umlaufenden Auflage oder Schulter. In diesem Fall könnte der Körper ggf. aus Metall bestehen. Dies hätte den Vorteil, dass -im Zusammenwirken mit einem ebenfalls metallischen Abstandhalterahmen- für den Körper dieselben (für Glas-Metall-Verbindungen) erprobten Kleber verwendet werden können wie für den Abstandhalterahmen selbst.

In der angedeuteten Ausführung kann die Platine nebst den von ihr getragenen Leiterabschnitten von der Seite des Körpers 7 montiert und ggf. demontiert werden, die im Einbauzustand vom Scheibenzwischenraum abgewandt ist und von außen zugänglich ist. Gegenüber der umgekehrten Montageweise (Platine nur zum Scheibenzwischenraum hin herausnehmbar) hat diese Ausführung den Vorteil, dass -bei Wahl einer geeigneten, lösbaren und doch gasdichten Verbindung zwischen Boden 10 / Platine und Körper 7- die Platine nebst den Leiterabschnitten unabhängig vom Körper 7 austauschbar wäre. Dies würde bei Bedarf eine Reparatur dieser Bauteile ohne weitere Beeinträchtigung der Mehrfachscheibe ermöglichen. Diese Möglichkeit kann durch die bereits erwähnte Verwendung von lötfrei lös- und fügbaren Steck-, Rast- oder Federkontakten innerhalb des Scheibenzwischenraums noch gefördert werden.

Schließlich kann die elektrische Isolierung zwischen den Leiterabschnitten bzw. Stiften 8 und dem Körper 7 auch durch geeignete Dicht- und Klebemassen hergestellt werden, welche die gasdichte und kurzschlusssichere Verbindung der Leiterabschnitte mit dem Körper bewirken. In diesem Fall könnte der Körper einstückig aus Metall bestehen. Die ggf. den Boden 10 der Ausnehmung bildende Platine kann aus Epoxydharz oder anderen geeigneten nicht leitfähigen Materialien bestehen und wird z. B. mit Epoxydharz-Kleber mit dem Körper 7 verklebt. In den Körper oder die Platine können die Stifte 8 schließlich auch eingelötet werden, wenn sie anderweitig sicher elektrisch gegeneinander und gegen den Körper isoliert sind. Hierzu kann die Platine z. B. eine metallische, ggf. in Leiterbahnen strukturierte Beschichtung umfassen, mit der die Stifte 8 direkt verlötbar sind.

In diesem Boden-Bereich und generell innerhalb des Körpers 7 könnten grundsätzlich noch weitere (hier nicht gezeigte) elektrische Bauelemente angeordnet werden, z. B. die bei Solarmodulen üblichen Bypass-Dioden.

Im Bereich der Leitungsdurchführung, ggf. auch umlaufend, kann man bei solchen Mehrfachscheiben, deren Ränder nicht von Rahmen umfasst sind, vorzugsweise eine optische Kaschierung vorsehen, z. B. in Gestalt der verbreiteten opaken Farbrahmen.

## Patentansprüche

1. Mehrfachscheibe (1), insbesondere Isolierglasscheibe, aus mindestens zwei flächigen Scheiben (2, 4) und einem diese miteinander verbindenden umlaufenden Abstandhalterahmen (3), welcher einen Scheibenzwischenraum (5) umschreibt, wobei in den Abstandhalterahmen eine Leitungsdurchführung eingesetzt ist, die einen mit dem Abstandhaiterahmen auf zwei Seiten gasdicht verbundenen, einen Abschnitt des Abstandhalterahmens mit bezüglich des Abstands der flächigen Scheiben gleichen Abmessungen ersetzenden Körper (7) und mindestens einen fest, gasdicht und gegenüber dem Abstandhalter isoliert in den Körper eingesetzten, sich zwischen dem Scheibenzwischenraum und dem Außenraum erstreckenden und beidseitig Anschlüsse umfassenden elektrischen Leiterabschnitt (8) umfasst, **dadurch gekennzeichnet, dass** der Körper (7) einen Eckbereich des Abstandhalterahmens (3) derart ersetzt, dass er zwei winklig zueinander verlaufende Schenkel des Abstandhalterahmens (3) miteinander verbindet.

2. Mehrfachscheibe nach Anspruch 1, **dadurch gekennzeichnet, dass** der Körper (7) zwei auskragende Zapfen (7Z) umfasst, die in den aus Hohlprofilen gebildeten Abstandhalterahmen (3) einsteckbar sind.

3. Mehrfachscheibe nach Anspruch 1 oder 2, bei der der Körper einstückig aus einem elektrisch nicht leitfähigen Material besteht, in welches die Leiterabschnitte eingebracht sind, oder aus einem elektrisch leitfähigen Material, in welches die Leiterabschnitte unter Zwischenschaltung einer elektrischen Isolierung eingebracht sind.

4. Mehrfachscheibe nach einem der vorstehenden Ansprüche, in der zum Einsetzen des mindestens einen Leiterabschnitts (8) in den Körper (7) mindestens ein zusätzliches Bauteil vorgesehen ist, gegenüber dem der oder jeder Leiterabschnitt (8) isoliert ist und/oder das selbst aus einem elektrisch nicht leitfähigen Material besteht.

5. Mehrfachscheibe nach einem der vorstehenden Ansprüche, in der mehrere Leiterabschnitte (8) in den Körper (7) oder in ein mit diesem verbundenes zusätzliches Bauteil eingesetzt sind.

6. Mehrfachscheibe nach einem der vorstehenden Ansprüche, in der die auf oder an dem Körper vorgesehenen Leiterabschnitte als den Körper durchdringende Durchführungen und/oder als Leiterbahnabschnitte ausgeführt sind.

7. Mehrfachscheibe nach einem der vorstehenden Ansprüche, in der der Körper (7) mindestens eine Ausnehmung (9) zum Aufnehmen eines Anschlusssteckers aufweist, in welche Ausnehmung die Leiterabschnitte (8) hineingeführt sind.

8. Mehrfachscheibe nach einem der vorstehenden Ansprüche, in der mindestens ein Leiterabschnitt mit einem Kontaktmittel versehen ist, das beim Auflegen des Körpers (7) auf die starre Scheibe (2, 4) unmittelbar in elektrisch leitenden Kontakt mit einem im Scheibenzwischenraum angeordneten Gegenkontaktmittel gelangt.

9. Mehrfachscheibe nach Anspruch 8, in der das Kontaktmittel als Steck-, Rast- oder Federkontakt ausgebildet ist.

10. Mehrfachscheibe nach einem der vorstehenden Ansprüche, bei der Lötverbindungen zwischen den Leiterabschnitten und Gegenkontaktmitteln vorgesehen sind.

11. Mehrfachscheibe nach einem der vorstehenden Ansprüche, in der mehrere Leitungsdurchführungen mit Körpern (7) in den Abstandhalterahmen (3) eingesetzt sind.

12. Mehrfachscheibe nach einem der vorstehenden Ansprüche, in deren Scheibenzwischenraum mindestens ein elektrisches Funktionselement angeordnet ist, das mithilfe der Leitungsdurchführung elektrisch anschließbar ist.

13. Mehrfachscheibe nach Anspruch 12 mit mindestens einem photovoltaischen Solarelement (6) als Funktionselement.

14. Mehrfachscheibe nach einem der vorstehenden Ansprüche, **dadurch gekennzeichnet, dass** der Körper (7) mindestens ein weiteres elektrisches Bauelement, z. B. eine Bypass-Diode eines Solarmoduls, umfasst.

15. Mehrfachscheibe nach einem der vorstehenden Ansprüche, **dadurch gekennzeichnet, dass** mindestens im Bereich der Leitungsdurchführung eine optische Kaschierung vorgesehen ist.
